(19) **Europäisches Patentamt**

**European Patent Office**

**Office européen des brevets**

(11) **EP 0 945 525 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(51) Int Cl.⁷: **C23C 14/54**, H01S 5/02, C23C 14/50

(21) Anmeldenummer: **99102284.9**

(22) Anmeldetag: **05.02.1999**

(54) **Beschichtungs-Verfahren und -Vorrichtung**

Coating process and apparatus

Procédé et appareillage de revêtement

(84) Benannte Vertragsstaaten:
**DE FR GB IT**

(30) Priorität: **21.03.1998 DE 19812562**

(43) Veröffentlichungstag der Anmeldung:
**29.09.1999 Patentblatt 1999/39**

(73) Patentinhaber: **Sacher, Joachim**
**35041 Marburg/Lahn (DE)**

(72) Erfinder: **Sacher, Joachim**
**35041 Marburg/Lahn (DE)**

(74) Vertreter: **Olbricht, Karl Heinrich, Dipl.-Phys.**
**Patentanwalt Karl Olbricht,**
**Am Weinberg 15**
**35096 Weimar/Niederweimar (DE)**

(56) Entgegenhaltungen:
GB-A- 2 246 905      GB-A- 2 291 889
US-A- 3 846 165      US-A- 5 221 636

- **PATENT ABSTRACTS OF JAPAN vol. 018, no. 416 (E-1588), 4. August 1994 & JP 06 125149 A (CANON INC), 6. Mai 1994**
- **SERENYI M ET AL: "DIRECTLY CONTROLLED DEPOSITION OF ANTIREFLECTION COATINGS FOR SEMICONDUCTOR LASERS" APPLIED OPTICS, Bd. 26, Nr. 5, 1. März 1987, Seiten 845-849, XP000709353**

**Beschreibung**

Die vorliegende Erfindung bezieht sich auf ein Verfahren zur Herstellung von Antireflexions-Beschichtungen (im folgenden auch als AR-Schichten bezeichnet) für Halbleiterlaser gemäß dem Oberbegriff von Anspruch 1.

Entspiegelte Halbleiterlaserdioden werden in modernen optischen Meßinstrumenten zur Gasanalyse und zur Interferometrie oder als optisches Radar eingesetzt. Weitere Anwendungen liegen im Feld der aktiven Lichtverstärkung.

Halbleiterlaser besitzen aufgrund des Brechungsindex-Sprunges zwischen Lasermaterial und Umgebung eine Reflektivität der Spiegelfacetten von typisch 32 %. Ein gängiges Verfahren zur Entspiegelung einer oder beider Laserfacetten ist deren Beschichtung mit einer dielektrischen Schicht einer Dicke, die dem Viertel der Zentralwellenlänge des Lasers entspricht. Der Wert des Brechungsindex wird gemäß dem harmonischen Mittel des Brechungsindex des Lasermaterials und der Umgebung gewählt. Bei geeigneter Kontrolle von Dicke und Wert des Brechungsindex der Entspiegelungsschicht können Werte des Minimums der Restreflektivität kleiner als $10^{-5}$ erreicht werden. In der Literatur sind hierfür mehrere Verfahren bekannt.

M. Serényi und H. J. Habermeier, beschreiben in *Directly controlled deposition of antireflection coatings for semiconductor lasers,* Applied Optics, Bd. 26 (1997), S. 845 ff ein Verfahren, bei dem der Laser elektrisch betrieben und die emittierte Lichtleistung beobachtet wird. Der Endpunkt der Beschichtung wird durch das Erreichen des Minimums der Lichtleistung bestimmt.

Bei einem Verfahren nach J. Landreau und H. Nakajima, *In-situ reflectivity monitoring of anti-reflection coatings on semiconductor laser facets through facet loss induced forward voltage changes,* Applied Physics Letters, Bd. 56 (1990), S. 2376 ff. wird der Laser elektrisch betrieben und die Spannung an seinem p-n-Übergang beobachtet. Der Endpunkt der Beschichtung wird durch das Erreichen des Maximums der Spannung am p-n-Übergang bestimmt.

In dem Artikel *Real-time in-situ monitoring of antireflection coatings of semiconductor laser amplifiers by ellipsometry*, Annual Meeting of the IEEE Lasers and Electro-Optics Society (LEOS), Nov. 1991 stellen M. Dagenais und I-Fan Wu ein Verfahren dar, bei dem der Laser elektrisch betrieben und der Schwellstrom des Lasers während der Beschichtung beobachtet wird, deren Endpunkt man bei Erreichen des Schwellstroms festlegt.

Den theoretischen Verlauf der Laserkenngrößen erhält man aus der stationären Lösung der Lasergleichungen. Zur Bestimmung der optischen Laserkenngrößen muß man noch zusätzlich die durch die Antireflexions-Beschichtung veränderte Auskoppelrate berücksichtigen. Insgesamt erhält man die folgenden Zusammenhänge.

$$P = \frac{J - \gamma \cdot N + \frac{\gamma \cdot \kappa}{G_N}}{\Gamma + \kappa} \qquad (1)$$

$$I_{th} = \gamma \cdot N + \gamma \cdot \frac{\kappa}{G_N} \qquad (2)$$

$$\kappa = -v_g \frac{\ln(1 - r_2)}{2L} \qquad (3)$$

$$1 - r_2 = \frac{(1 - r_{12}^2)(1 - r_{23}^2)}{1 + r_{12}^2 r_{23}^2 + 2 r_{12} r_{23} \cdot \cos 2\beta} \qquad (4)$$

$$\beta = 2\pi \cdot \frac{n_2 \cdot h(t)}{\lambda} \qquad (5)$$

Hierbei sind: $P$ die von der rückseitigen Laserfacette emittierte Lichtleistung, J die normierte Schwellstromdichte, $\gamma$ die Elektronenzerfallsrate, $N$ die Transparenzladungsträgerdichte, $G_N$ der differentielle Gewinn, $I_{th}$ die normierte Schwellstromdichte des Lasers, $v_g$ die Gruppengeschwindigkeit des Lichts, $L$ die Länge des Lasers, $r_{12}$ die Reflektivität der Grenzfläche zwischen AR-Schicht und Laser, $r_{23}$ die Reflektivität zwischen AR-Schicht und der Umgebung, $n_2 \cdot h$ die optische Schichtdicke der Antireflexionsschicht mit dem Brechungsindex $n_2$ und der geometrischen Dicke $h$ und $\lambda$ die Zentralwellenlänge des Lasers. Die anderen Laserparameter lassen sich nach dem gleichen Formalismus bestimmen. $\beta$ ist ein Schichtdicken-Parameter, nämlich die Phase des zurückgekoppelten Lichtes.

Das Verfahren der *in-situ*-Beobachtung der Laserkenngrößen bei der Entspiegelung von Halbleiterlaserdioden ist herkömmlich auf die Beschichtung kleiner Stückzahlen beschränkt. Ein Grund liegt darin, daß die Zeitdauer, die man zum Erzeugen eines geeigneten Vakuums braucht, sehr viel größer ist als die Beschichtungszeit der einzelnen Laserdioden. Zur Befriedigung der Nachfrage hoher Stückzahlen werden jedoch schnelle Beschichtungsverfahren benötigt, die höchste Güte bei größtmöglicher Effizienz gewährleisten.

Das von M. Ettenberg et al. in US-PS 3,846,165 vorgeschlagene Verfahren, einen Laser als Monitorlaser zu verwenden und simultan mehrere Laser oder Laserbarren zu beschichten, ermöglicht zwar die Herstellung großer Stückzahlen von Entspiegelungen, liefert aber Ergebnisse, die für viele Anwendungen nicht genügen, weil bei der vorgesehenen Messung der vom Laser erzeugten Lichtleistung die Wellenlängenverschiebung des Lasers während des Beschichtungsvorgangs nicht berücksichtigt wird. Für höchste Qualitätsansprüche ist dieses Verfahren daher nicht anwendbar. Weitere Ursachen hierfür sind unterschiedliche Dicken in der Facettenpassivierung (Vorbeschichtungen) kommerziell erhältlicher Halbleiterlaser, ferner räumliche Variationen der gewachsenen Schichten bezüglich der Dicke wie auch des Wertes des Brechungsindex.

Moderne Hochleistungslaserdioden besitzen in der Regel eine Entspiegelungsschicht einer Laserfacette mit einer Reflektivität von typisch 5 % bis 10 %. Entspiegelung höchster Güte kann deshalb durch Aufwachsen einer einzigen Entspiegelungsschicht nicht erzielt werden, weshalb es notwendig ist, entweder die Vorbeschichtung zu entfernen oder mindestens zwei Schichten von unterschiedlicher Dicke und unterschiedlichem Brechungsindex aufzuwachsen. Diese werden im folgenden als Teilschichten bezeichnet. In ihrer vorgenannten Veröffentlichung haben M. Dagenais und I-Fan Wu vorgeschlagen, zur Kontrolle des Entfernungsprozesses der Vorbeschichtung bzw. zur Kontrolle der aufgewachsenen Schichtdicken einen *in-situ*-Ellipsometer einzusetzen. Problematisch ist jedoch bei der Anwendung dieses Verfahrens neben den hohen Kosten des Meßgerätes, daß dieses auf einen Meßpunkt von typisch 10 μm x 10 μm einjustiert werden muß, was einem wirtschaftlichen Einsatz entgegensteht.

Es ist ein wichtiges Ziel der Erfindung, ein Verfahren bereitzustellen, um die Herstellung von Antireflexionsschichten höchster Güte für Halbleiterlaserdioden bei hohen Stückzahlen mit wirtschaftlichen Mitteln zu ermöglichen. Insbesondere soll ein Minimum der Restreflektivität besser als $10^{-5}$ erzielbar sein.

Hauptmerkmale der Erfindung sind in Anspruch 1 angegeben. Ausgestaltungen sind Gegenstand der Ansprüche 2 bis 4.

Die Erfindung geht aus von einem Verfahren zur Herstellung von Antireflexions-Beschichtung (nachfolgend AR-Schichten genannt) von minimaler Restreflektivität für Halbleiterdiodenlaser (nachfolgend HD-Laser genannt), wobei wenigstens zwei Teilschichten von unterschiedlicher Dicke sowie unterschiedlichem Brechungsindex aufgebracht werden, wobei die Schichtdicke durch in-situ-Beobachtung eines Laserparameters, nämlich des von der Frontfacette und/oder Rückfacette eines Lasers emittierten Laserlichts, der elektrischen Spannung am p-n-Übergang des Lasers oder der Quanteneffizienz des von der Frontfacette und/oder des von der Rückfacette des Lasers emittierten Laserlichts oder des Schwellstroms des Lasers, bestimmt wird, und wobei man in einen Rezipienten mehrere HD-Laser gleichzeitig einbringt, wovon einer als Monitorlaser benutzt wird, während weitere HD-Laser simultan mitbeschichtet werden. Dabei sieht die Erfindung gemäß dem kennzeichnenden Teil von Anspruch 1 vor, daß alle Laser bis zu einem sicheren Wert der Schichtdicke in einem einzigen Verfahrensschritt gemeinsam beschichtet werden, worauf man die Schichtdicke jedes einzelnen Lasers mit *in-situ*-Beobachtung eines oder mehrerer Laserparameter optimiert. Hierdurch wird die hohe Qualität des Verfahrens - bei dem die HD-Laser zwischendurch nicht aus dem Rezipienten entnommen werden müssen - auf die Produktion hoher Stückzahlen übertragen, was mit bisherigen Verfahren nicht möglich war.

Die Ansprüche 2 bis 4 definieren, in welchen Bauformen die Laser in den Rezipienten eingebracht werden. Insbesondere kann man gemäß Anspruch 2 alle Laser fertig konfektioniert einbringen. Eine Alternative besteht laut Anspruch 3 darin, daß mindestens ein Laser fertig konfektioniert ist, d.h. daß er als Laser im Rezipienten betrieben werden kann, während die weiteren eingebrachten Laser noch nicht fertig konfektioniert sind. Ferner können die nicht fertig konfektionierten Laser gemäß Anspruch 4 in Chipform oder in Barrenform vorliegen.

Eine geeignete Vorrichtung besteht aus einem Rezipienten, der wenigstens eine Beschichtungsquelle, eine oder mehrere Halterungen für Halbleiterlaser, eine oder mehrere Blenden, eine Steuerungs- und Meßeinrichtung sowie Verbindungsleitungen enthält. Jeder Beschichtungsquelle ist mindestens eine bewegliche Laserhalterung zur Beschichtung der Laserdiode zugeordnet, und davor befindet sich wenigstens eine Blende, welche den bzw. die Laser wahlweise zur Beschichtung freigibt, was einzeln oder gemeinsam bewirkt werden kann. Mit einem Magazinteil sind die zu beschichtenden bzw. beschichteten Laser in den Beschichtungsteil des Rezipienten überführbar

Neben der Beschichtungskammer kann eine schwenk- und/oder verschiebbare Blendenhalterung angeordnet sein. Damit wird das Lasermagazin praktisch zu einem Teil der Beschichtungskammer; man benötigt also keine aufwendigen motorgetriebenen Schlitten oder ähnliche Mechanismen. Vorteilhaft ist es, wenn alle Laser auf einer Linie mit identischer Beschichtungsrate und identischem Brechungsindex liegen und eine oder mehrere Blenden während des Entspiegelungsprozesses ganz oder teilweise vor den bzw. jeden Laser bewegbar sind. Hierdurch wird eine Einzel-Optimierung jedes Lasers ermöglicht, indem während der Beschichtung einzelne Laser oder alle bis auf einen Laser durch Blenden abgedeckt werden.

Während des Prozesses ist mehr als ein Laser elektrisch betreibbar, wobei Einrichtungen zum Messen bzw. Beobachten der Laserparameter in solcher Ausbildung vorhanden sein können, daß bei mindestens einem Laser, vorzugsweise bei mehreren oder allen in der Laserhalterung enthaltenen Lasern zumindest ein Laserparameter kontinuierlich oder diskret beobachtbar ist. Dadurch wird ein hohes Maß an Effizienz und Prozeßsicherheit gewährleistet.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Darin ist bzw. sind:

Fig. 1 — eine schematische Darstellung einer Beschichtungsanlage für Halbleiterlaser,

Fig. 2A — ein typischer Verlauf der Lichtleistung eines Lasers während eines Entspiegelungsprozesses,

Fig. 2B — ein typischer Verlauf des Schwellstroms eines Lasers während eines Entspiegelungsprozesses,

Fig. 2C — ein typischer Verlauf der Spannung am p-n-Übergang eines Lasers während eines Entspiegelungsprozesses,

Fig. 3A bis 3 C — schematische Darstellungen der Wachstumsrate aufgebrachter Schichten bei rotationssymmetrischen bzw. linearen Beschichtungsparametern,

Fig. 4A und 4B — je eine schematische Darstellung bevorzugter Bauformen der Befestigung des Halbleiterlasers im Laserhalter,

Fig. 5 bis 7 — schematische Darstellungen - jeweils mit Teilbildern - bevorzugter Bauformen eines Laserhalters für rotationssymmetrische Beschichtung und Blendenanordnung, und

Fig. 8 bis 11 — schematische Darstellungen - jeweils mit Teilbildern - bevorzugter Bauformen eines Laserhalters für translationssymmetrische Beschichtung und Blendenanordnung.

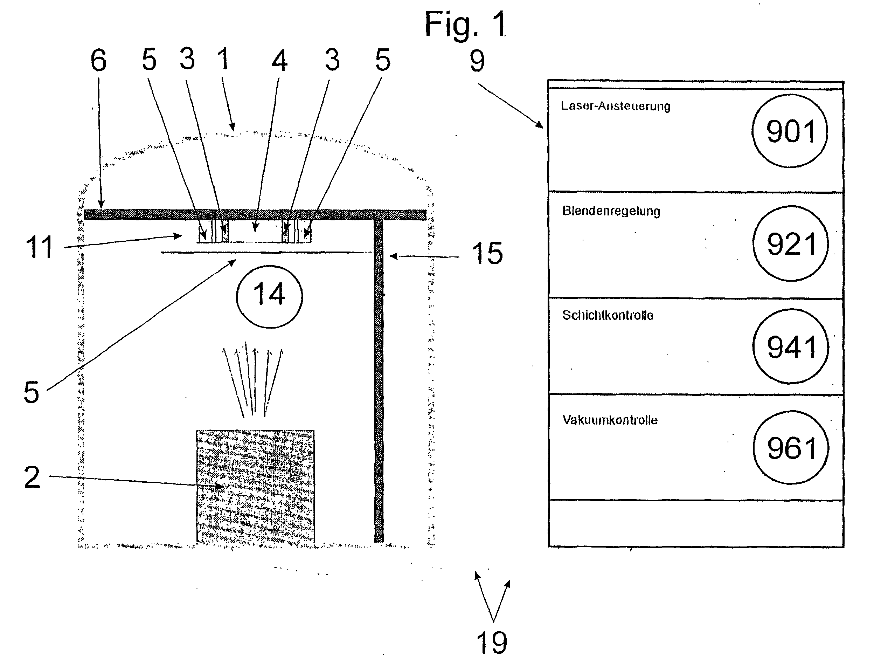

In Fig. 1 ist eine Beschichtungsanlage für Halbleiterlaser schematisch dargestellt. Sie besteht aus einem Rezipienten 1, in dem der Beschichtungsprozeß stattfindet, und einer Steuerungs- und Meßeinrichtung 9, die alle prozeßrelevanten Parameter kontrolliert. Im Ausführungsbeispiel ist der Rezipient 1 in einen oberen Magazinteil 11 und einen darunter befindlichen Beschichtungsteil 14 aufgeteilt. Im Beschichtungsteil 14 ist eine Beschichtungsquelle 2 auf dem Boden des Rezipienten 1 angeordnet. Halbleiterlaser 3 sind in einer Laserhalterung 4 montiert, die sich auf einer Trägerplatte 6 befindet. Die Halbleiterlaser 3 sind mit einer mindestens einer Blende 5 abgedeckt, die an einer Halterung 15 befestigt ist und zur individuellen Freigabe der einzelnen Laser dient. Zusätzlich kann die gesamte Lasereinheit 3, 4 durch eine Blende 5 abgedeckt werden. Die z.B. in einem (nicht gezeichneten) Schaltschrank untergebrachte Kontrolleinheit 9 ist modular aufgebaut.

Sie besteht, wie rechts in Fig. 1 schematisch angedeutet ist, aus einer Laseransteuerung 901, aus einer Blendenregelung 921, einer Schichtkontrolleinheit 941 sowie aus einer Vakuumregelung 961. Diese Einheiten sind mit der Beschichtungsquelle 2, der Laserhalterung 4 und/oder der Blendenhalterung 15 betätigungsverbunden, z.B. durch elektrische und/oder optische Leitungen 19.

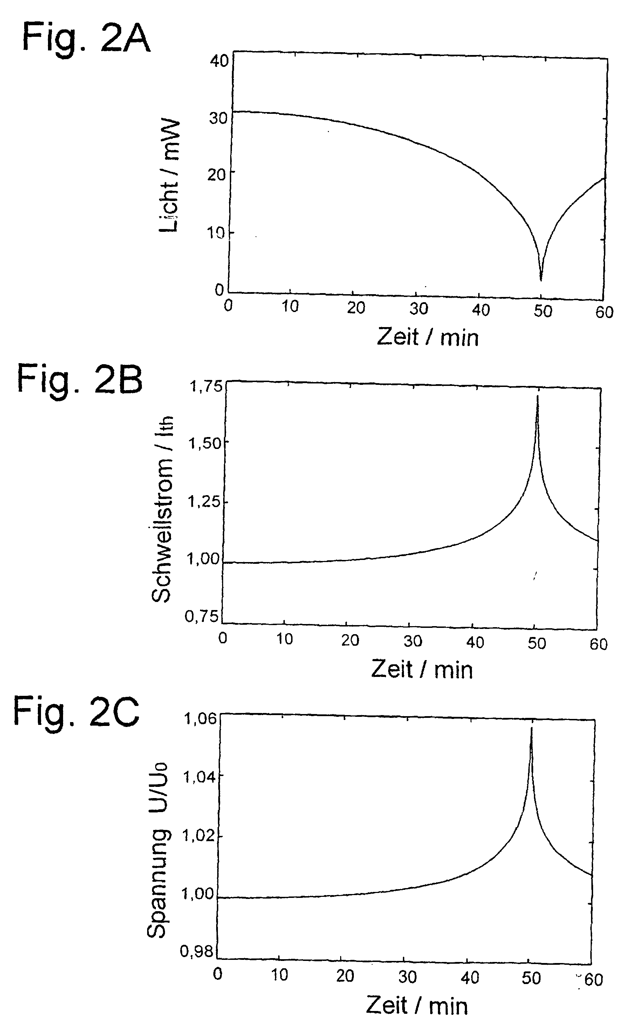

Aus Fig. 2 geht der typische Verlauf einiger Laserparameter als Funktion der Beschichtungszeit t während eines Entspiegelungsprozesses hervor. Teilbild 2A zeigt den zeitlichen Verlauf der Lichtleistung P für eine Einschicht-Entspiegelung. Der beste Wert der Antireflexions-Beschichtung wird im Bereich des Minimums erreicht. Teilbild 2B zeigt den Verlauf des Schwellstroms I für eine Einschicht-Entspiegelung. Der beste Wert wird im Bereich des Maximums erzielt. Teilbild 2C zeigt den Verlauf der Spannung U am p-n-Übergang des Lasers, ebenfalls für eine Einschicht-Entspiegelung. Wiederum wird der beste Wert im Bereich des Maximums erreicht.

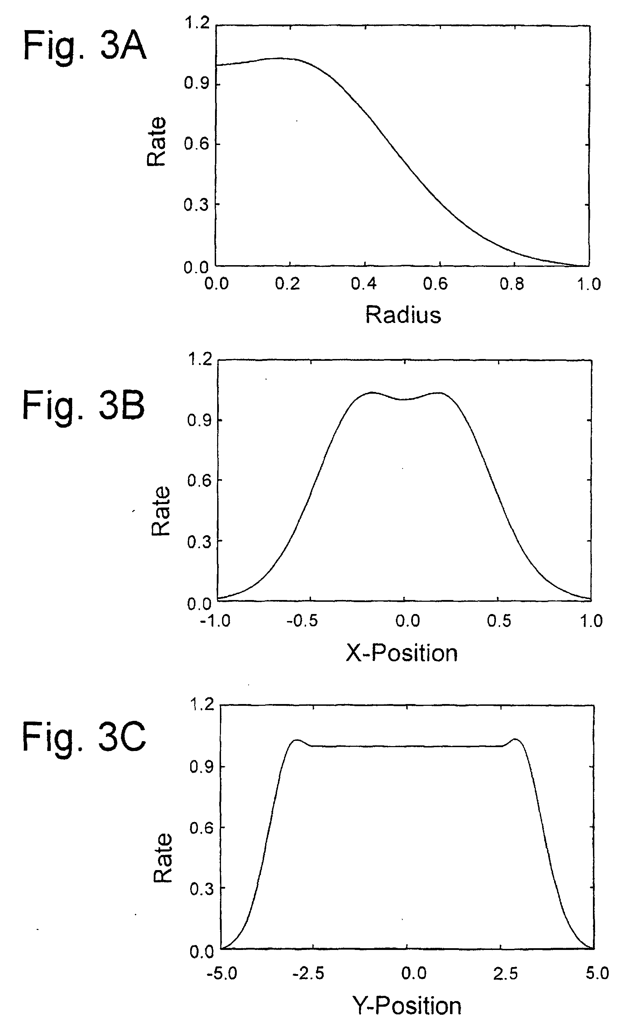

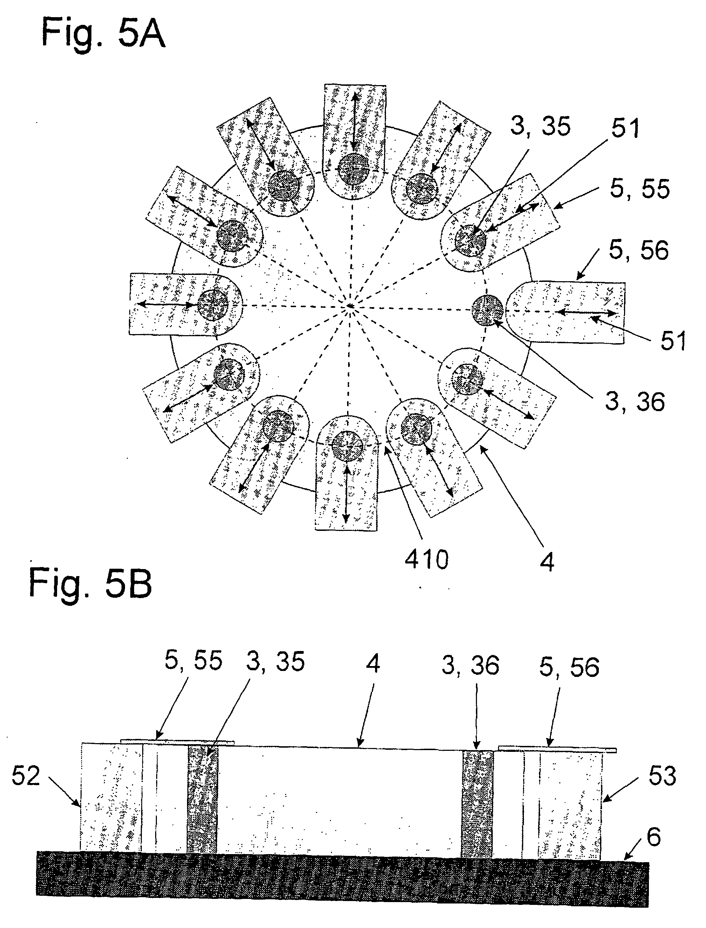

Fig. 3 zeigt den Verlauf der Wachstumsrate R als Funktion des Ortes, relativ zur Beschichtungsquelle. Man ersieht aus Teilbild 3A die Beschichtungsrate als Funktion des Radius eines rotationssymmetrisch zur Beschichtungsquelle angeordneten Laserhalters. Hierbei besteht eine erhebliche Abhängigkeit der Wachstumsrate vom Radius, weshalb erfindungsgemäß vorgesehen ist, die Laser in diesem Fall auf einem Kreis oder Ring mit gleicher Wachstumsrate anzuordnen (vergl. Fig. 5 bis 7).

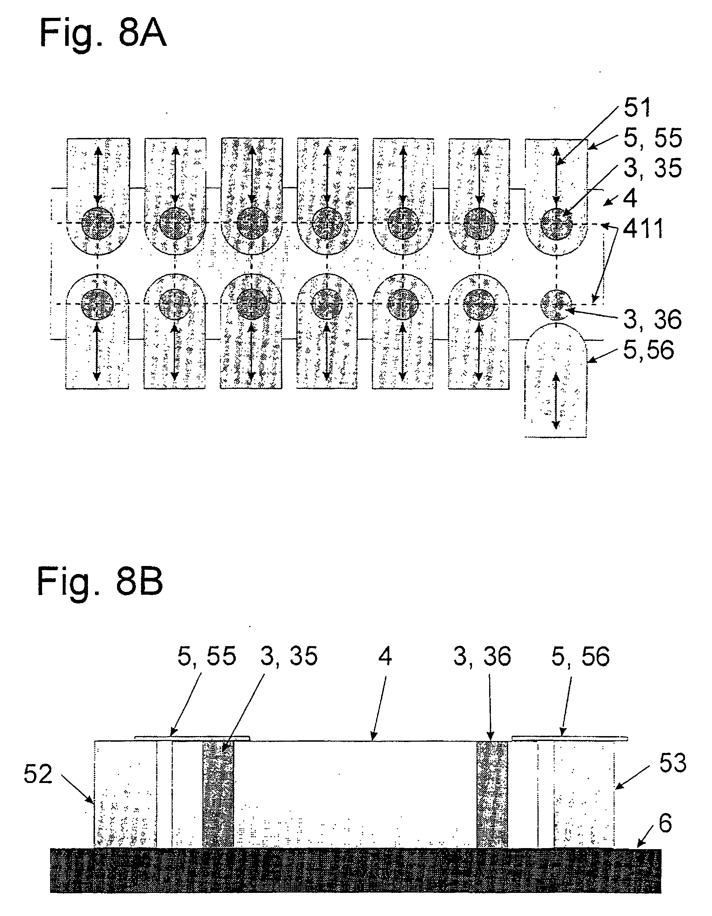

Der Verlauf der Beschichtungsrate für eine Beschichtungsquelle, die über einen Bereich translationsinvariante Geometrie aufweist, ist aus den Teilbildern 3B und 3C ersichtlich. Dabei liegt die X-Richtung senkrecht zur Invarianzrichtung, während die Y-Richung für einen gewissen Bereich Translationsinvarianz aufweist. Vorteilhaft ordnet man die Dioden daher entlang einer zentralen Linie (x = 0) oder entlang zweier gleichweit vom Zentrum entfernter Linien an (z.B.: x = 0.3); Ausführungsbeispiele ergeben sich aus Fig. 8 bis 11.

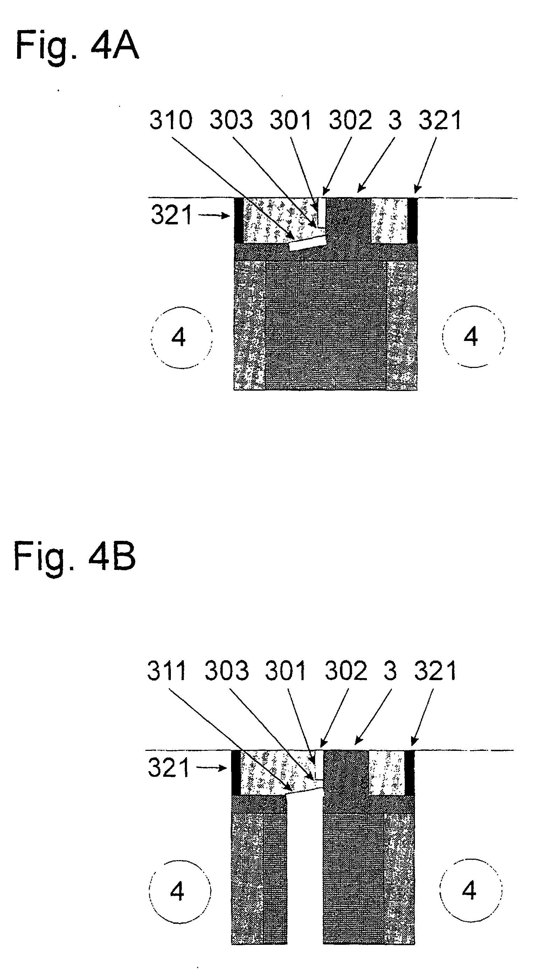

Fig. 4 zeigt zwei schematische Darstellungen der Befestigung. Die Halbleiterlaser 3 werden im Laserhalter 4 z.B. mit einer Hohlschraube 321 festgeschraubt. Die Frontfacette 302 eines Laserchips 301 ist so ausgerichtet, daß sich die dielektische Beschichtung darauf niederschlägt. Die rückwärtige Facette 303 des Laserchips 301 ist der Beschichtung abgewandt. Im Teilbild Fig. 4A ist hinter dem Laser ist eine Photodiode 310 angebracht, mit der das von der rückseitigen Laserfacette 303 emittierte Laserlicht beobachtet wird. Gemäß Fig. 4B ist anstelle der Photodiode 310 eine Glasfaser 311 hinter dem Laser 3 angebracht, mit der das von der rückseitigen Laserfacette 303 emittierte Licht für eine detailliertere Beobachtung aus dem Rezipienten 1 herausgeführt wird.

Fig. 5 stellt schematisch eine bevorzugte Bauform des Laserhalters bzw. Lasermagazins 4 für rotationssymmetrische Beschichtung dar. Fig. 5A zeigt eine Draufsicht auf den Laserhalter 4 zusammen mit der Anordnung der Blenden 5; ein Querschnitt der Anordnung ist aus Fig. 5B ersichtlich. Die Halbleiterlaser 3 sind auf einer Linie 410 mit gleicher Beschichtungsrate und gleichem Brechungsindex angeordnet. Jeder Laser 3 kann einzeln von einer Blende 5 abgedeckt oder durch Translation der Blende 5 in Richtung des Pfeils 51 zur Beschichtung freigegeben werden. Um die Bewegung der Blende 5 in Richtung des Pfeils zu realisieren, kann man die Blende auf einem Verschiebeschlitten 52 bzw. 53 plazieren, der durch einen (nicht dargestellten) Schrittmotor angetrieben wird. Laser 35 ist durch Blende 55 abgedeckt und damit vor Beschichtung geschützt. Eine in Richtung des Pfeils 51 verschobene Blende 56 gibt Laser 36 zur Beschichtung frei. Mit einer solchen Anordnung ist es möglich, zunächst alle Halbleiterlaser gleichzeitig zu beschichten, die relevanten Laserparameter jedes Lasers zu beobachten und dann beim Erreichen der besten Dicke der jeweiligen Teilschicht jeden Laser individuell mit Hilfe der zugeordneten Blende abzudecken. Alternativ lassen sich alle Laser bis zu einem sicherem Wert der Schichtdicke gemeinsam beschichten, worauf man alle Laser bis auf einen mit Hilfe der Blenden abschottet und dann die jeweilige Teilschicht individuell für jeden Laser optimiert.

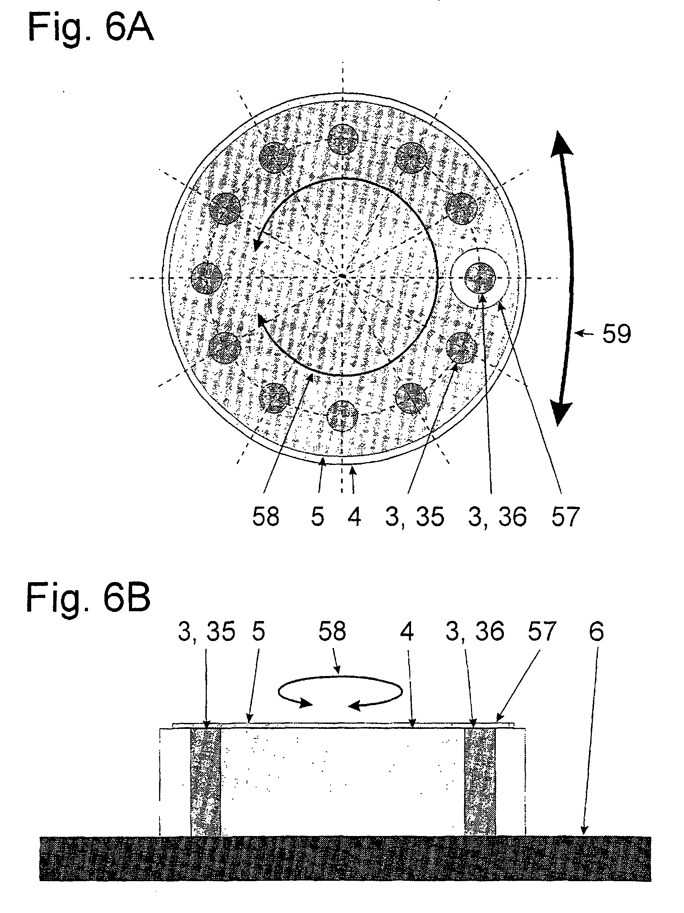

Fig. 6 zeigt schematisch eine weitere bevorzugte Bauform des Laserhalters bzw. Lasermagazins 4 für rotationssymmetrische Beschichtung. Fig. 6A zeigt eine Draufsicht auf den Laserhalter 4 zusammen mit der Anordnung der Blende 5.; ein Querschnitt der Anordnung geht aus Fig. 6B hervor. Die Halbleiterlaser 3 sind hierbei auf einer Linie 410 mit gleicher Beschichtungsrate und gleichem Brechungsindex angeordnet. Blende 5 kann entsprechend Pfeil 59 ganz zur Seite bewegt werden, um alle Laser 3 gleichzeitig zur Beschichtung freizugeben. Wenn Blende 5 vor dem Laserhalter 4 positioniert ist, gibt eine Öffnung 57 genau einen Laser 3 bzw. 36 frei. Durch Rotation der Blende 5 entsprechend Pfeil 58 kann jeder Laser 3 einzeln zur Beschichtung freigeben werden. Mit der in Fig. 6 gezeigten Anordnung ist es ebenfalls möglich, zunächst alle Halbleiterlaser gleichzeitig bis zu einem sicherem Wert der Schichtdicke zu beschichten, danach alle Laser bis auf einen mit Hilfe der Blende 5 abzuschotten und dann die jeweilige Teilschicht für jeden Laser einzeln zu optimieren.

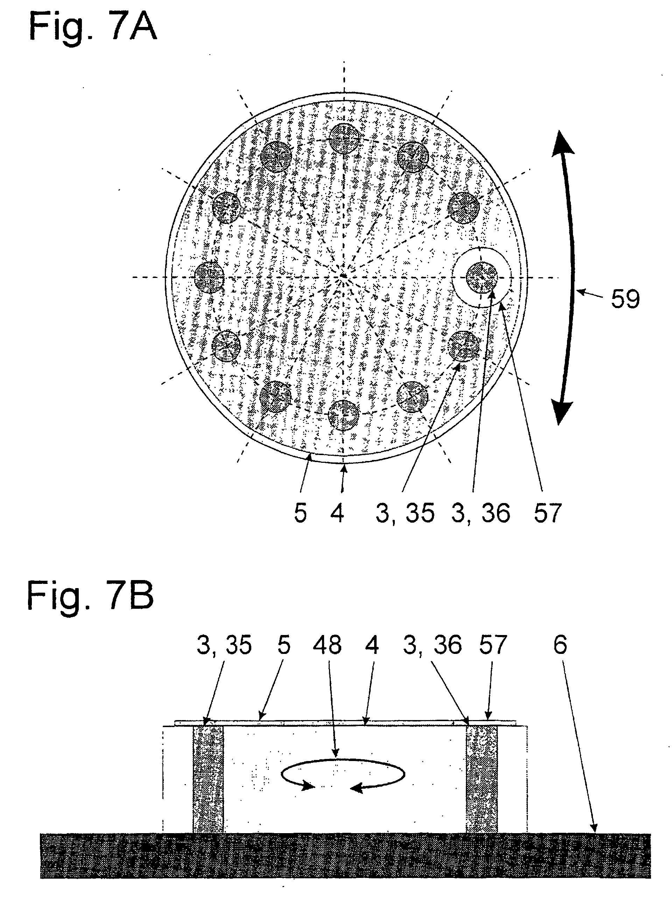

Eine Modifikation ist aus Fig. 7 ersichtlich, wobei nicht die Blende, sondern der Laserhalter 4 entsprechend Pfeil 48 drehbar angeordnet ist. Das Beschichtungsverfahren ist im übrigen zu dem für Fig. 6 beschriebenen äquivalent.

Fig. 8 zeigt eine schematische Darstellung einer bevorzugten Bauform des Laserhalters bzw. Lasermagazins 4 für translationssymmetrische Beschichtung. Man sieht in Fig. 8A eine Draufsicht auf den Laserhalter 4 zusammen mit der Anordnung von Blenden 5; Fig. 8B zeigt einen Längsschnitt der Anordnung. Die Halbleiterlaser 3 sind entlang zwei Linien 411 mit gleicher Beschichtungsrate und gleichem Brechungsindex angeordnet. Jeder Laser 3 kann einzeln von einer Blende 5 abgedeckt oder durch Translation der Blende 5 in Richtung des Pfeils 51 zur Beschichtung freigegeben werden. Beispielsweise ist Laser 35 durch Blende 55 abgedeckt und damit vor Beschichtung geschützt. Wird Blende 56 in - wie gezeichnet - Pfeilrichtung 51 verschoben, so wird Laser 36 zur Beschichtung freigegeben. Auch mit einer derartigen Anordnung ist es möglich, zunächst alle Halbleiterlaser gleichzeitig zu beschichten, die relevanten Laserparameter jedes Lasers zu beobachten und dann beim Erreichen der besten Dicke der jeweiligen Teilschicht jeden Laser individuell mit Hilfe der zugeordneten Blende abzudecken. Alternativ ist es wiederum möglich, alle Laser bis zu einem sicherem Wert der Schichtdicke gemeinsam zu beschichten, danach alle Laser bis auf einen mit Hilfe der Blenden abzuschotten und dann die jeweilige Teilschicht individuell für jeden Laser einzeln zu optimieren.

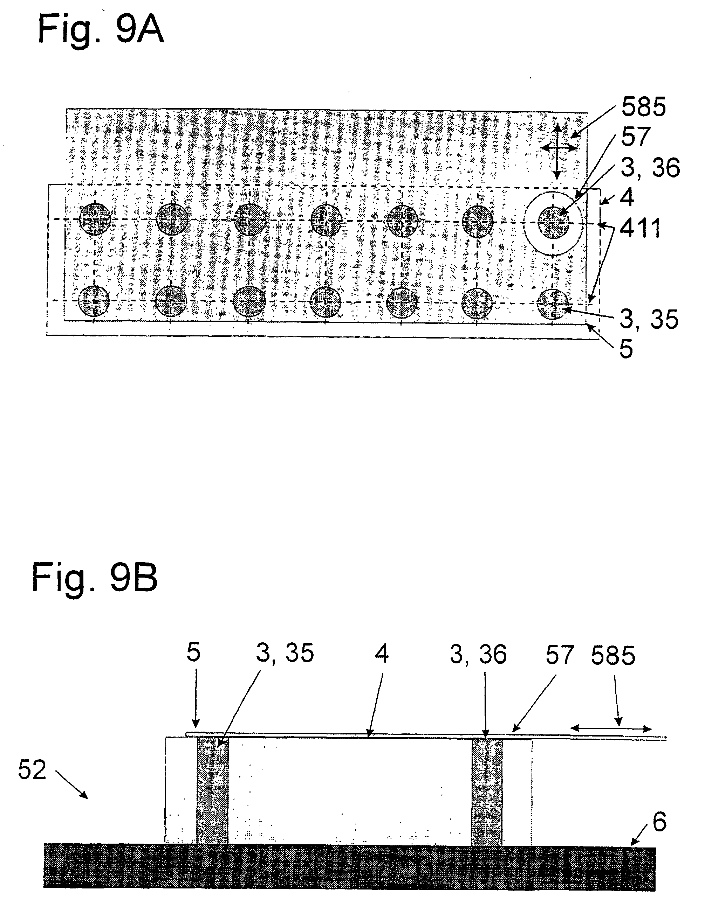

In Fig. 9 ist eine abgewandelte Bauform des Laserhalters bzw. Lasermagazins 4 für translationssymmetrische Beschichtung schematisch dargestellt. Fig. 9A zeigt eine Draufsicht auf den Laserhalter 4 zusammen mit der Blende 5; Fig. 9B zeigt die Anordnung im Längsschnitt. Die Halbleiterlaser 3 sind entlang zwei Linien 411 mit gleicher Beschichtungsrate und gleichem Brechungsindex angeordnet. Blende 5 ist in Pfeilrichtung 585 zur Seite bewegbar, so daß alle Laser 3 gleichzeitig zur Beschichtung freigegeben werden. Sobald Blende 5 vor dem Laserhalter 4 positioniert ist, gibt eine Öffnung 57 genau einen Laser 3 bzw. 36 zur Beschichtung frei. Blende 5 kann aber entsprechend Pfeil 585 auch so verschiebbar sein, daß jeder Laser 3 einzeln zur Beschichtung freigegeben wird. Mit der in Fig. 9 gezeigten Anordnung ist es ebenfalls möglich, zunächst alle Halbleiterlaser gleichzeitig bis zu einem sicherem Wert der Schichtdicke zu beschichten, danach alle Laser bis auf einen mit Hilfe der Blende 5 abzuschotten und dann die jeweilige Teilschicht individuell für jeden Laser zu optimieren.

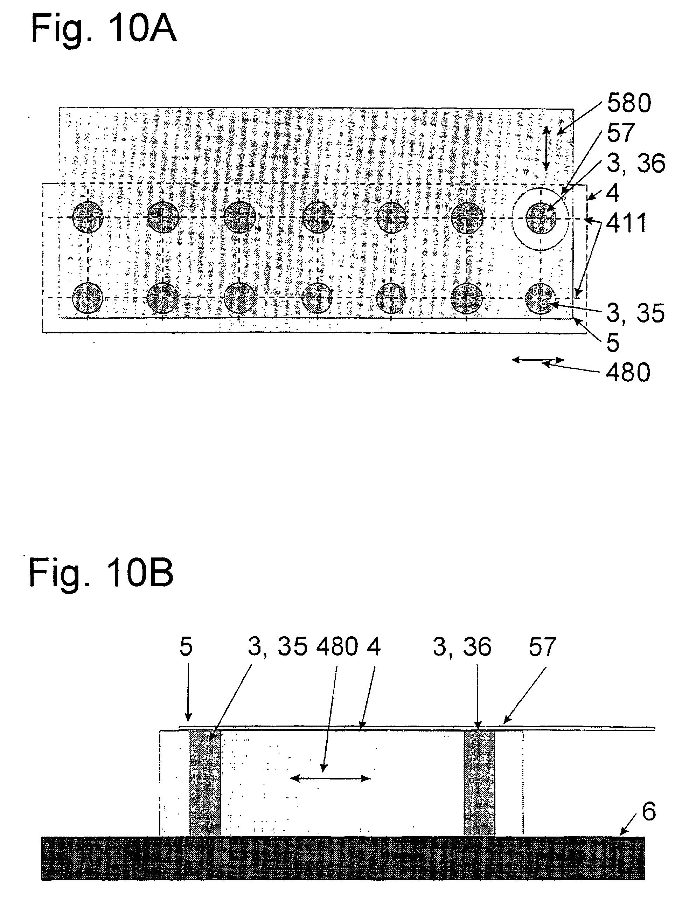

Fig. 10 zeigt eine Modifikation, bei der die Blende 5 nur in einer Richtung entsprechend Pfeil 580 verschiebbar ist; andererseits kann der Laserhalter 4 entsprechend Pfeil 480 verschoben werden. Das Beschichtungsverfahren ist ansonsten zu dem bei Fig. 9 beschriebenen äquivalent.

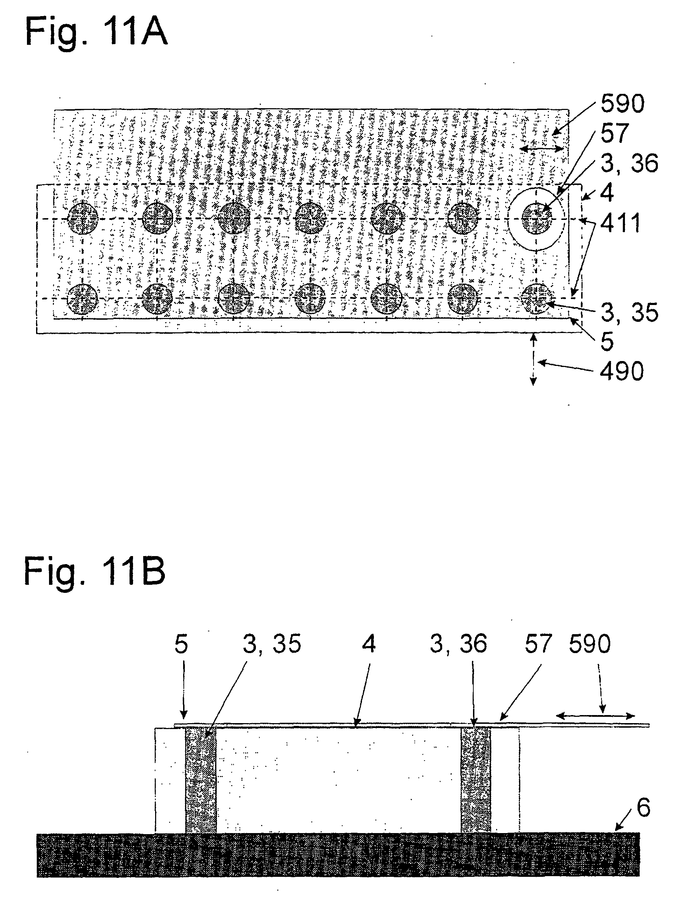

Man kann ferner vorsehen, daß die Blende 5 in Richtung eines Pfeils 590 und der Laserhalter in Richtung eines Pfeils 490 verschiebbar ist, wie in Fig. 11 dargestellt.

Die Erfindung ist nicht auf die erläuterten Beispiele beschränkt; vielmehr sind zahlreiche Variationen möglich, ohne den Rahmen der Erfindung gemäss den Ansprüchen 1-4 zu verlassen. Man erreicht in jedem Falle eine erhebliche Verbesserung der *in-situ*-Beobachtung von Laserdioden während der Antireflexions-Beschichtung. Darüberhinaus wird die hohe Qualität des Verfahrens auf die Produktion hoher Stückzahlen übertragen, was mit bisherigen Mitteln nicht möglich war.

In bevorzugter Ausführungsform der Erfindung zur Herstellung von Antireflexions-Schichten von minimaler Restreflektivität für Halbleiterlaserdioden beobachtet man *in situ* das von der Frontfacette und/oder Rückfacette eines Lasers emittierte Laserlicht und bestimmt die Dicke einzelner Teilschichten anhand eines *in situ* beobachteten Laserparameters, insbesondere durch Vergleich mit einem theoretisch berechneten Zeitverlauf. Als Laserparameter kann die Leistung oder die Quanteneffizienz des vom Laser emittierten Lichts benutzt werden, wahlweise auch seine Wellenlänge, die elektrische Spannung am p-n-Übergang des Lasers oder sein Schwellstrom. Man kann mehrere Halbleiterdiodenlaser gleichzeitig in einen Rezipienten 1 einbringen und z.B. einen fertig konfektionierten Laser 3 als Monitorlaser benutzen, während weitere Laser (3) simultan bis zu einem Referenzwert mitbeschichtet werden, worauf jeder Laser 3 einzeln mit *in-situ*-Beobachtung der Teilschichtdicke optimiert wird. Nicht fertig konfektionierte Laser lassen sich in Chip- oder in Barrenform in den Rezipienten 1 einbringen. Eine besonders geeignete Vorrichtung umfaßt außer der Beschichtungsquelle 2 mindestens eine bewegliche Laserhalterung 4 und/oder mindestens eine davor befindliche Blende 5, die wahlweise während der Entspiegelung vor den bzw. jeden Laser 3 bewegbar ist. Dieser kann samt seiner als Magazin 11 ausgebildeten Halterung in eine Beschichtungskammer 14 überführt werden, neben der sich bevorzugt sich eine schwenk- und/oder verschiebbare Blendenhalterung 15 befindet. Die Laser 3 können ring- bzw. kreisförmig oder linear angeordnet sein. Zumindest einer ist im Rezipienten 1 elektrisch betreibbar und mittels einer Steuerungs- und Meßeinrichtung 9 auf wenigstens einen Laserparameter hin kontinuierlich oder diskret beobachtbar. Ein Schaltschrank kann eine Laser-Ansteuerung 901, eine Blendenregelung 921, eine Schichtkontrolle 941 und/oder eine Vakuumkontrolle 961 enthalten. Die Steuerungs- und Meßeinrichtung 9, d.h. die Kontroll-Elektronik, ist mit der Beschichtungsquelle 2, der Laserhalterung 4 und/oder der Blendenhalterung 5 z.B. durch elektrische und/oder optische Leitungen 19 betätigungsverbunden.

## Bezugszeichenliste

| | |
|---|---|
| 1 | Rezipient |
| 2 | Beschichtungsquelle |
| 3 | (Halbleiter-)Laser |
| 4 | Laserhalterung/-Magazin |
| 5 | Blende |
| 6 | Trägerplatte |
| 9 | Steuerungs- und Meßeinrichtung |
| 11 | Magazinteil |
| 14 | Beschichtungsteil |
| 15 | Blendenhalterung |
| 19 | Leitungen |
| 35, 36 | Laser |
| 48, 51 | Pfeilrichtung |
| 52, 53 | Blendenträger/Schlitten |
| 55, 56 | Blenden |
| 57 | Öffnung |
| 58, 59 | Pfeilrichtung |
| 301 | Laserchip |
| 302 | Fronfacette |
| 303 | Rückfacette |
| 310 | Photodiode |
| 311 | Glasfaser/Lichtieiter |
| 321 | Hohlschraube |
| 410, 411 | Linien |
| 480, 490 | Pfeilrichtungen |
| 580, 585, 590 | Pfeilrichtungen |
| 901 | Laser-Ansteuerung |
| 921 | Blendenregelung |
| 941 | Schichtkontrolle(einheit) |
| 961 | Vakuumkontrolle(einheit) |

## Patentansprüche

1. Verfahren zur Herstellung von Antireflexions-Beschichtungen von minimaler Restreflektivität für Halbleiterdiodenlaser (HD-Laser), wobei wenigstens zwei Teilschichten von unterschiedlicher Dikke sowie unterschiedlichem Brechungsindex aufgebracht werden, und wobei die Schichtdicke durch in-situ-Beobachtung eines Laserparameters, nämlich des von der Frontfacette und/oder Rückfacette eines Lasers emittierten Laserlichts, der elektrischen Spannung am p-n-Übergang des Lasers oder der Quanteneffizienz des von der Frontfacette und/oder des von der Rückfacette des Lasers emittierten Laserlichts oder des Schwellstroms des Lasers, bestimmt wird, und wobei man in einen Rezipienten mehrere HD-Laser gleichzeitig einbringt, wovon einer als Monitorlaser benutzt wird, während weitere HD-Laser simultan mitbeschichtet werden, **dadurch gekennzeichnet, daß** bei mindestens einer Teilschicht alle im Rezipienten eingebrachten HD-Laser gemeinsam in einem einzigen Verfahrensschritt bis zu einem Referenzwert beschichtet werden, worauf man die Schichtdicke jedes HD-Lasers einzeln mit in-situ-Beobachtung eines oder mehrerer Laserparameter optimiert.

2. Verfahren nach Anspruch 1, **dadurch gekennzeichnet, daß** man alle HD-Laser fertig konfektioniert in den Rezipienten einbringt.

3. Verfahren nach Anspruch 1, **dadurch gekennzeichnet, daß** mindestens ein fertig konfektionierter HD-Laser und im übrigen nicht fertig konfektionierte HD-Laser in den Rezipienten eingebracht werden.

**4.** Verfahren nach Anspruch 3, **dadurch gekennzeichnet, daß** die nicht fertig konfektionierten HD-Laser in Chipform oder in Barrenform in den Rezipienten eingebracht werden.

## Claims

**1.** Process for the production of antireflection coatings with minimum residual reflectivity for semiconductor diode lasers (SD lasers), wherein at least two partial layers of different thicknesses as well as of different refractive indices are deposited and wherein the layer thickness is determined by in-situ monitoring of a laser parameter, i.e. the laser light emitted by the front facet and/or the back facet of a laser, the electric tension at the p-n transition of the laser or the quantum efficiency of the laser light emitted by the front facet and/or the back facet of a laser or the threshold current of the laser, and wherein several SD lasers are placed into a recipient at the same time, one of them being used as monitor laser while other SD lasers are also coated simultaneously, **wherein** all SD lasers placed into the recipient are coated together in a single process step with at least one partial layer up to a reference value, whereupon the layer thickness of each SD laser is optimized individually by in-situ monitoring of one or several laser parameters.

**2.** Process according to claim 1, **wherein** all SD lasers are placed into the recipient as finished articles.

**3.** Process according to claim 1, **wherein** at least one SD laser as a finished article and otherwise unfinished SD lasers are placed into the recipient.

**4.** Process according to claim 3, **wherein** the unfinished SD lasers are placed into the recipient in the form of chips or bars.

## Revendications

**1.** Procédé de fabrication de revêtements antiréfléchissants d'une réflexivité résiduelle minimale pour des lasers à diodes à semiconducteurs (lasers DS), au moins deux couches partielles d'épaisseurs différentes ainsi que d'indices de réfraction différents étant appliquées, et l'épaisseur de couche étant déterminée par observation in situ d'un paramètre du laser, c'est-à-dire de la lumière laser émise par la facette frontale et/ou arrière d'un laser, de la tension électrique à la jonction p-n du laser ou de l'efficience quantique de la lumière laser émise par la facette frontale et/ou arrière du laser, ou du courant seuil du laser, et plusieurs lasers DS étant placés simultanément dans un récipient, dont l'un est utilisé en tant que laser moniteur alors que d'autres lasers DS sont aussi revêtus simultanément, **caractérisé en ce que** pour au moins une couche partielle, tous les lasers DS placés dans le récipient sont revêtus ensemble jusqu'à une valeur de référence lors d'une seule phase du procédé, à la suite de quoi on optimise individuellement l'épaisseur de couche de chaque laser DS avec observation in situ d'un ou plusieurs paramètres du laser.

**2.** Procédé selon la revendication 1, **caractérisé en ce que** tous les lasers DS sont placés entièrement confectionnés dans le récipient.

**3.** Procédé selon la revendication 1, **caractérisé en ce que** l'on place au moins un laser DS entièrement confectionné et par ailleurs des lasers DS non entièrement confectionnés dans le récipient.

**4.** Procédé selon la revendication 3, **caractérisé en ce que** les lasers DS non entièrement confectionnés sont placés dans le récipient sous forme de chips ou de barres.

Fig. 1

EP 0 945 525 B1

Fig. 2A

Fig. 2B

Fig. 2C

Fig. 3A

Fig. 3B

Fig. 3C

## Fig. 4A

310 303 301 302 3 321

321 →

## Fig. 4B

311 303 301 302 3 321

321 →

## Fig. 5A

## Fig. 5B

Fig. 6A

58    5    4    3, 35    3, 36    57

← 59

Fig. 6B

3, 35    5    58    4    3, 36    57    6

13

## Fig. 7A

5    4    3, 35  3, 36  57

59

## Fig. 7B

3, 35    5    48    4    3, 36   57    6

## Fig. 8A

51
5, 55
3, 35
4
411
3, 36
5,56

## Fig. 8B

5, 55    3, 35    4    3, 36    5, 56

52    53    6

## Fig. 9A

585
57
3, 36
4
411

3, 35
5

## Fig. 9B

5　3, 35　4　3, 36　57　585

52

6

## Fig. 10A

## Fig. 10B

## Fig. 11A

## Fig. 11B